(19)

Europäisches
Patentamt
European
Patent Office
Office européen
des brevets

(11) **EP 2 866 339 A1**

(12) **EUROPEAN PATENT APPLICATION**

(43) Date of publication:
   **29.04.2015   Bulletin 2015/18**

(21) Application number: **13189899.1**

(22) Date of filing: **23.10.2013**

(51) Int Cl.:
   *H02M 1/36* (2007.01)          *H02M 3/07* (2006.01)
   *G11C 5/14* (2006.01)

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**

(71) Applicant: **EM Microelectronic-Marin SA
   2074 Marin (CH)**

(72) Inventors:
   • **Plavec, Lubomir
     61200 Brno (CZ)**
   • **Subrt, Ondrej
     10900 Praha 10 (CZ)**

(74) Representative: **Giraud, Eric et al
   ICB
   Ingénieurs Conseils en Brevets SA
   Faubourg de l'Hôpital 3
   2001 Neuchâtel (CH)**

(54) **Charge pump circuit**

(57)   A charge pump circuit comprises a charge pump unit, which is operable to output a voltage which increases from a low or zero voltage to a high voltage. The charge pump circuit further comprises a control unit configured to control the ramp-up of the output voltage by a variable ramp rate which comprises at least a first rate which precedes a second rate, the first rate being greater than the second rate, and the second rate being applied as the magnitude of the output voltage approaches that of the high voltage. Accordingly, since the second rate is applied after and is less than the first rate and is applied proximate the high voltage, the peak power consumption can be reduced when compared to a constant ramp-up rate applied over the same ramp-up time.

Fig. 5

## Description

Field of the Invention

The present invention relates to the field of charge pumps and more particularly to controlling an increase of an output from a charge pump which may be used to enable the operation of a memory unit.

Background and Prior Art

Charge pumps are typically used as peripheral elements on a circuit that needs higher voltages than the supply level. An example is a non-volatile memory, such as flash memory, where charge pumps are used to provide the high voltages used in programming and erasing memory cells, and also for the various voltages used in sensing and verifying the memory cells.

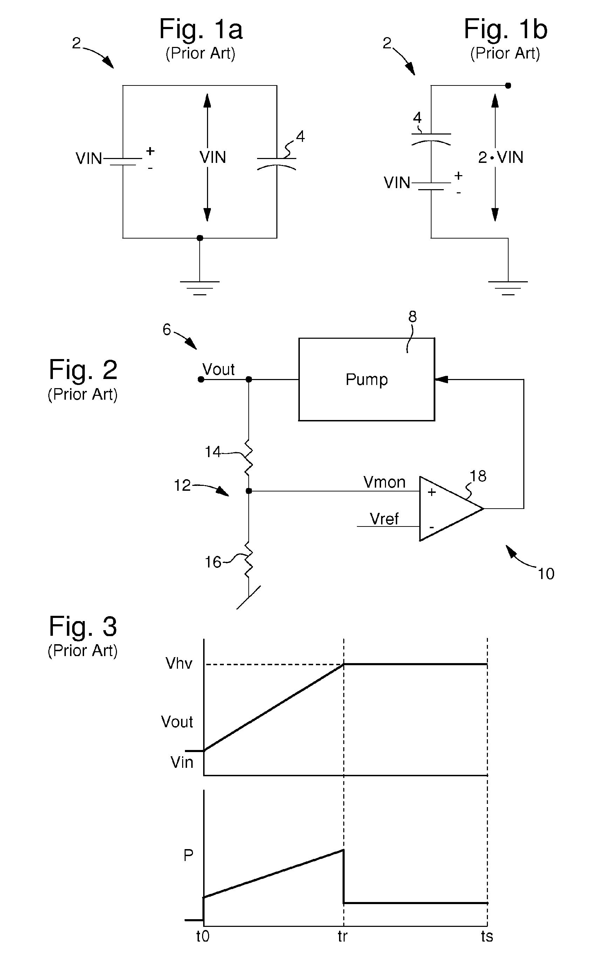

Charge pumps use a switching process to provide a DC output voltage which is larger than the DC input voltage. In general, a charge pump will have a capacitor coupled to switches between an input and an output. In an exemplary arrangement of a charge pump, during one clock half cycle (the charging half cycle) the capacitor couples in parallel to the input voltage so as to charge up to the input voltage. During a second clock half cycle (the transfer half cycle) the charged capacitor is coupled in series with the input voltage so as to provide an output voltage twice the level of the input voltage. This process is illustrated in the illustrative charge pump 2 of Figures 1a and 1b. In Figure 1a, a capacitor 4 is arranged in parallel with the input voltage Vin to show the charging half cycle. In Figure 1b, the charged capacitor 4 is arranged in series with the input voltage to show the transfer half cycle. As seen in Figure 1b, the positive terminal of the charged capacitor 4 is $2 \cdot Vin$ with respect to ground.

Figure 2 is a circuit diagram of an exemplary arrangement of a charge pump circuit 6 comprising a charge pump 8 and a voltage regulator 10. Typically the charge pump 8 has an input that includes a clock signal which is used to generate the output voltage Vout. The voltage regulator is operable to regulate Vout and conventionally comprises a voltage divider 12 of R1 14 and R2 16 connected in series between Vout and ground to generate voltage Vmon that is compared with a reference voltage Vref by a comparator 18 to generate a FLAG signal. The clock signal can then be gated with the FLAG signal to produce a charge pump clock. The reference voltage Vref is based on a reliably known value, for example it may be generated by a band-gap generator. The resistances of R1 and R2 and Vref are used to set a maximum reference high voltage output for Vout. The voltage regulator shown in Figure 2 is limited to provide a single regulated value as the ratio of resistances in the regulation circuit is fixed. However, multiple regulated outputs, such as those needed for a programming voltage can be provided by use of a variable resistive divider.

When using a charge pump to supply a non-volatile memory unit, the supply operation can be considered to comprise two stages, as illustrated graphically in Figure 3. During a first stage from time t0 to tr the output voltage from the charge pump Vout is ramped from the low power voltage Vin to the high voltage Vhv. This stage is associated with high power consumption P since the output capacitance of the charge pump needs to be charged at least partially to the high voltage level. During ramp-up a controlled linear ramp is used to increase cycling performance of the memory unit and to lower the power consumption. During a second stage from time tr to ts the voltage Vout and power consumption P are steady state, wherein the charge pump supplies only the leakage current and as such the power consumption is lower.

A drawback of the above operation is that the power consumption of the charge pump can be large. More particularly, during ramp-up the power consumption increases, particularly as Vhv is approached. This is because it is increasingly difficult for the charge pump to follow the linear pattern of the ramp since a charge pump generally becomes weaker with increasing Vout as more power is required to achieve the same output current. In addition leakage currents increase with increasing Vout. The power consumption is therefore highest prior to achieving Vhv. Such a power requirement can impose a restriction on the specification of the charge pump, for example the size and quantity of the capacitors it comprises. Moreover, in applications where there is limited input power, such as radio frequency identification devices (RFID), wherein the power is delivered over an electric field, the power consumption can limit the write distance of the RFID tag.

Summary of the Invention

It is therefore an object of the present invention to provide a charge pump circuit which is operable to increase a low input voltage to the high voltage output with reduced peak power consumption and increased efficiency.

It would be advantageous to provide a charge pump circuit which is more compact for a given high voltage output.

It would be advantageous to provide a charge pump circuit which can be effectively used in applications wherein there is limited input power.

It would be advantageous to provide a charge pump circuit which is cost effective to manufacture.

It would be advantageous to provide a charge pump circuit which is reliable.

Objects of the invention are achieved by a charge pump circuit and memory device according to claims 1, 15, 16 and 17. The dependent claims describe various advantageous features of the invention.

Disclosed herein and according to a first aspect of the invention is a charge pump circuit comprising a charge pump unit, the charge pump unit being operable to output a voltage which increases from a low or zero voltage to a high voltage. The low or zero voltage may be considered a first voltage and the high voltage may be considered a second voltage and the voltage may be increased positively or negatively. The charge pump circuit further comprises a control unit configured to control the ramp-up of the output voltage by a variable ramp rate which comprises at least a first rate which precedes a second rate, the first rate being greater than the second rate, and the second rate being applied as the magnitude of the output voltage approaches that of the high voltage. Accordingly, since the second rate is applied after and is less than the first rate and is applied proximate the high voltage, the peak power consumption can be reduced when compared to a constant ramp-up rate applied over the same ramp-up time. Herein ramp-up refers merely to an increasing voltage during the ramp-up stage, for example, it is not limited to a linear ramp such that ramp-up may also refer to curved ramp rates.

In an advantageous embodiment the second rate is applied when the output voltage is particularly close to the high voltage, for example, it is within the range of 0-5% or 0-10% or 0-20% less than the magnitude of the high voltage. In an advantageous embodiment the first rate is applied when the output voltage is particularly close to the low or no voltage, for example, it is within the range of 0-5% or 0-10% or 0-20% of the magnitude of the high voltage greater than that of the low or no voltage. The first and/or second rate may be applied for a substantial period of time, for example at about 0-5% or 0-10% or 10-50% of a ramp-up time which the voltage is increased over. The first rate may be applied during a first half of the ramp-up time and the second rate may be applied over a second half of the ramp-up time.

In a preferred embodiment, the control unit is configured such that the second rate is less than a rate achieved when the voltage is increased from low or zero voltage to a high voltage at a constant rate. In this way the peak power consumption of the charge pump can be reduced during the period of time the second rate is applied over. The control unit may also be configured such that the first rate is greater than a rate achieved when the voltage is increased from low or zero voltage to a high voltage at a constant rate. In this way increasing the rate at initiation of the voltage ramp-up can be used to offset the time penalty in reducing the rate at the end of ramp-up. This enables optimisation of the ramp-up time, for example the ramp-up time may be set such that operations such as read and write operations on a memory unit are optimised.

In an advantageous embodiment the control unit is configured such that a plurality of ramp-up rates are applied with generally decreasing rates.

In an advantageous embodiment the control unit is configured such that a plurality of ramp-up rates are applied with consecutively decreasing rates.

The control unit may be operable to control the profile of a curve defined by the output voltage vs. time such that the curve is a variety of shapes, for example it may be piecewise linear or of an exponentially decreasing gradient or at least partially stepped such that when averaged the desired first or second rate is achieved or have a curved profile with a decreasing rate.

It will be appreciated that small scale oscillations may be present in the output of the charge pump unit and/or the control unit, for instance, due to noise in the output or the small steps in an embodiment where the output is increased in a stepping manner. In such an instance the rate refers to the averaged rate, wherein sufficient averaging is applied to remove the small scale oscillations to leave a generally smooth curve or non-fluctuating line.

The control unit may comprise a regulator unit to regulate the high voltage. The control unit may comprise ramp-up control unit to ramp the output voltage from the low or zero voltage to a high voltage. In an embodiment comprising a regulation unit and ramp-up control unit may operate in a closed loop manner, for example the regulator unit is operable to sense the output voltage as part of a feedback loop. With such an arrangement the ramp-up control unit may be operable to define a reference ramp-up voltage, the reference ramp-up voltage increasing from an initial voltage to a reference voltage, wherein the reference ramp-up voltage is representative of and is used to control the output voltage of the charge pump unit. The ramp-up control unit may be configured such that the reference ramp-up voltage increases from the initial voltage to the reference voltage in a variety of manners, for example, a linear piece-wise manner or a stepped manner or may increase at an exponentially decreasing rate. In the case of the stepped manner, the control unit or charge pump unit or ramp-up control unit may be configured to smooth the resultant output voltage, for example by means of a low-pass signal averaging filter, such that the profile of the output voltage is smooth or curved. The ramp-up control unit may comprise a circuit having a divider arrangement comprising a plurality of current sources arranged in parallel to each other, with each current source having a switch, the divider arrangement further comprising a capacitor, wherein the reference ramp-up voltage is measured over the capacitor. The ramp-up control unit may comprise a circuit having a digital counter and a D/A converter, wherein the reference ramp-up voltage is measured from the output of the D/A converter. The ramp-up control unit may comprise an RC circuit having a divider arrangement, wherein the reference ramp-up voltage is measured over the capacitor.

Alternatively, the control unit may process the output of the charge pump unit directly, for example in an open loop manner. The output of the charge pump unit can be, for example, connected to a memory unit through a current source to achieve a controlled ramp of the output voltage. The value of the current of the current source can be changed during ramp-up to achieve a particular ramp-up profile. The value of the current can be changed, for example, by switching several current sources in parallel.

Disclosed herein and according to a second aspect of the invention there is provided a method of operating a charge pump unit of a charge pump circuit to output an output voltage that increases from a low or zero voltage to a high voltage. The method comprises using a control unit of the charge pump circuit to ramp-up of the output voltage by a variable ramp rate which comprises at least a first rate which precedes a second rate, the first rate being greater than the second rate, and the second rate being applied as the magnitude of the output voltage approaches that of the high voltage. The charge pump circuit may comprise any of the features of the first aspect of the invention.

Disclosed herein and according to a third aspect of the invention there is provided a memory device comprising a memory unit. The memory device comprises a charge pump circuit according to the first aspect of the invention. The charge pump circuit is operable to supply an output voltage to the memory unit to enable the memory unit to perform one or more operations.

Disclosed herein and according to a fourth aspect of the invention there is provided a method of operating a memory unit of a memory device, the method comprises operating a charge pump unit of a charge pump circuit to output an output voltage to the memory unit that increases from a low or zero voltage to a high voltage to enable the memory unit to perform one or more operations. The method comprises using a control unit of the charge pump circuit to ramp-up of the output voltage by a variable ramp rate which comprises at least a first rate which precedes a second rate, the first rate being greater than the second rate, and the second rate being applied as the magnitude of the output voltage approaches that of the high voltage.

The memory unit, may comprise a non-volatile memory like flash memory or EEPROM.

The memory device may comprise a portable device such as a USB stick. It may also comprise transponder comprising an RFID chip, a memory unit and an antenna for receiving a field to power the chip and memory unit.

Further objects and advantageous features of the invention will be apparent from the claims, from the detailed description, and annexed drawings.

Brief Description of the Drawings

For a better understanding of the invention, and to show how embodiments of the same may be carried into effect, reference will now be made, by way of example, to the accompanying diagrammatic drawings in which:

Figures 1a and 1b are simplified diagrams of a charging cycle and a transfer cycle in a conventional charge pump,

Figure 2 is a circuit diagram of a conventional charge pump circuit, comprising a regulator and a charge pump,

Figure 3 is a graphical illustration of a prior art operation of the charge pump circuit of Figure 2,

Figure 4 is a circuit diagram of a charge pump circuit according to an embodiment of the invention,

Figure 5 is a circuit diagram of a ramp-up control unit according to a first embodiment of the invention,

Figure 6 is an illustration of an operation of the ramp-up control unit of Figure 5,

Figure 7 is an illustration of an operation of a charge pump unit according to the first embodiment of the invention,

Figure 8 is a circuit diagram of a ramp-up control unit according to a second embodiment of the invention,

Figure 9 is an illustration of an operation of the ramp-up control unit of Figure 8,

Figure 10 is a circuit diagram of a ramp-up control unit according to a further second embodiment of the invention,

Figure 11 is an illustration of an operation of the ramp-up control unit of Figure 10,

Figure 12 shows a plot of experimental results from a charge pump unit according to the second embodiment of the invention,

Figure 13 is a circuit diagram of a ramp-up control unit according to a third embodiment of the invention,

Figure 14 is an illustration of an operation of the ramp-up control unit of Figure 13,

Figure 15 is an illustration of an operation of a charge pump unit according to the third embodiment of the invention, and

Figure 16 is a circuit diagram of a ramp-up control unit according to a fourth embodiment of the invention.

Detailed Description

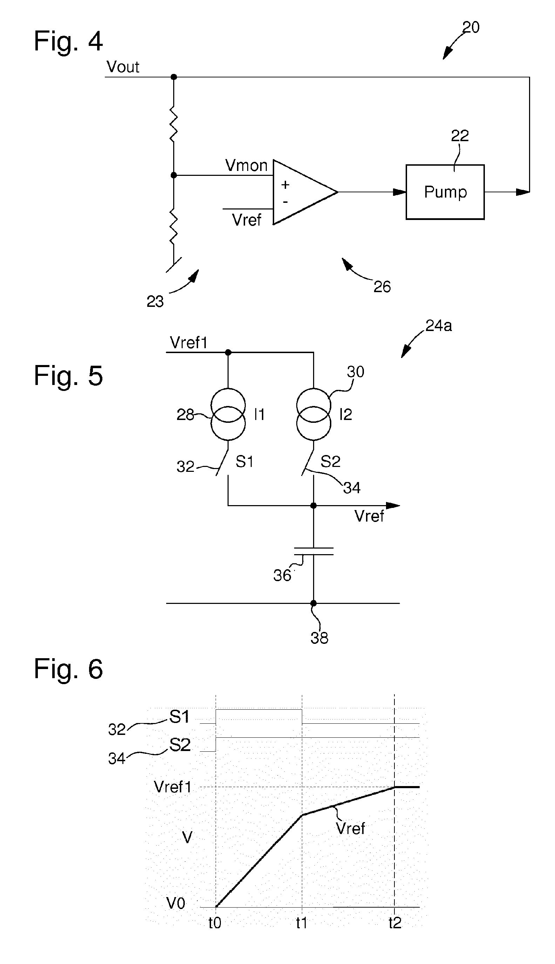

As shown in part in Figure 4, a charge pump circuit 20 comprises a charge pump unit 22 and a charge pump control unit 23. The control unit 23 is operable to control the output voltage Vout of the charge pump unit 22 from a low input voltage Vin to a high output voltage Vhv. More particular, it is operable to control a ramp-up from Vin to Vhv, as well as Vhv.

In an advantageous embodiment the charge pump control unit 23 comprises a ramp-up control unit 24a as shown in a first embodiment in Figure 5. The control unit may also comprise a regulator unit 26. As previously mentioned, the regulator unit 26 can comprise a voltage divider here composed by two resistors connected in series between Vout and ground to generate an intermediate voltage Vmon that is compared with a reference voltage Vref, by a comparator. Of course the voltage divider can also be composed by two series connected capacitors not shown.

According to an exemplary embodiment of the charge pump circuit 20 shown in Figure 4, the regulator unit 26 is operable to regulate the high output voltage Vhv of the charge pump unit 22. The ramp-up control unit 24a shown in Figure 5 is operable to control the ramp-up of Vout from Vin to Vhv. The regulator unit 26 is configured to regulate Vout as part of a closed loop system. In the exemplary embodiment the regulator unit comprises a conventional divider, comparator regulator. However it will be appreciated that other suitable regulators may be used.

With reference to Figure 4, the regulator unit 26 is operable to measure the output voltage Vout of the charge pump unit 22, by means of comparing an intermediate voltage Vmon and a reference voltage Vref. When Vout is equal to Vhv the charge pump unit 22 may be controlled by the regulator unit to output a steady state voltage of Vhv.

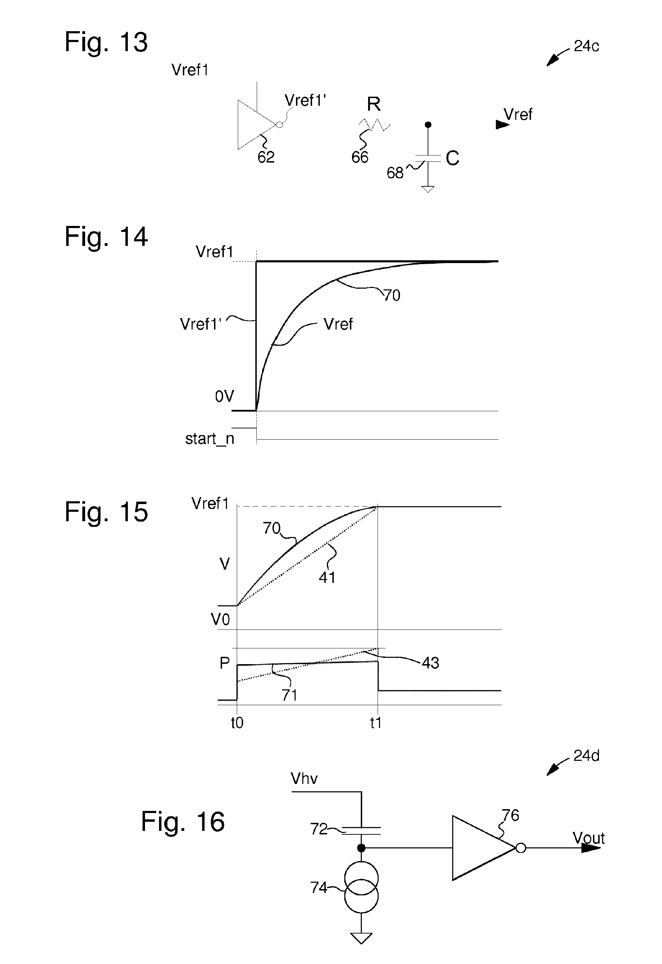

In first, second and third embodiments that are discussed following, the ramp-up control unit 24a, 24b, 24c shown in Figures 5, 8 and 13 is arranged to control the output of the charge pump unit 22 via the regulator unit 26. With such an arrangement the ramp-up control unit 24a, 24b, 24c may be connected to or form part of the regulator unit 26. However, it will be appreciated that in other embodiments the ramp-up control unit may be arranged to interface directly with the charge pump unit 22 to control the output, for example it may form part of the charge pump unit 22 and may operate as part of an open loop system without a regulator unit. An example of such an arrangement is provided herein as the fourth embodiment described hereafter as shown in Figure 16.

The ramp-up control unit 24a, 24b, 24c is operable to control the increase of Vout from the low power input voltage Vin up to high output voltage Vhv to optimise the operation of the charge pump unit 22. More particularly, the ramp-up control unit 24a, 24b, 24c is operable to provide an alternative to the prior art linear ramp-up which lowers the peak current consumption and therefore enables operation at lower power levels. This is achieved by configuring the ramp-up control unit 24a, 24b, 24c to reduce the rate at which the Vout is increased as Vhv is approached. A further effect of such an operation is that when used with a memory unit, such as a non-volatile memory like flash memory or EEPROM, the tunnelling current of the memory cell is lowered due to slower rising of the voltage at the end of the ramp which leads to increased cycling performance.

In addition, the ramp-up control unit 24a, 24b, 24c may be configured to increase the rate at which Vout is increased when Vout initially diverges from Vin, since a higher rate in this region does not have a substantial effect on the peak current consumption. In addition, increasing the rate at initiation of ramp-up can be used to offset the time penalty in reducing the rate at the end of ramp-up. This enables optimisation of the ramp-up time, for example the ramp-up time may be set such that operations such as read and write operations on a memory unit are optimised.

It will be appreciated that the ramp-up control unit 24a, 24b, 24c may be implemented in a variety of ways to achieve the above function. In the following first, second and third example embodiments the ramp-up control unit 24a, 24b, 24c is operable to manipulate Vref of the regulator unit 26 during ramp-up to achieve control of the ramp-up phase, although it will be appreciated that other implementations are possible. For example, the ramp-up control unit 24a, 24b, 24c may be arranged to interface with other parts of the regulator unit 26, such as the bottom side of the divider.

A first embodiment of a ramp-up control unit 24a will now be described, wherein a linear piece-wise ramp curve is achieved. Figures 5 and 6 show an example of the first embodiment, wherein a first and second current source 28, 30 are arranged in parallel. A first switch 32 is arranged in series with the first current source 28, and a second switch 34 is arranged in series with the second current source 30. A reference voltage Vref1 is arranged to supply the current sources, and is based on a reliably know value, for example it may be generated by a bandgap generator. A capacitor 36 is connected to ground voltage 38 (or a low voltage) and to the current sources 28, 30 respectively through first and second switches 32, 34. Between the current sources 28, 30 and capacitor 36 there is located an output node, such that the output of the ramp-up control unit Vref, is the voltage over the capacitor 36. The output Vref is supplied to the comparator of the regulation unit 26 as shown in Figure 4.

Referring now to Figure 6, Vref the output of the ramp-up unit 24a is shown with respect to time. Vref is ramped up from V0, which in this example is 0 V. However it will be appreciated in the embodiments that Vref may alternatively be ramped up from an initial value different from 0 V. From t0 to t1 the first and second switches 32 and 34 are closed, and Vref comprises the summation of currents from the first and second current sources 28, 30 on capacitor 36. From t1 to t2 the first switch 32 is open and the second switch 34 remains closed such that Vref comprises the current from the second current source 30 on capacitor 36 only. Accordingly, from t0 to t1 Vref increases at a greater rate than between t1 and t2.

The comparator of the regulator unit 26 as shown in Figure 4 processes Vref and Vmon and controls the charge pump unit 22 to provide Vout in corresponding proportions to Vref. For example, at t0 V0 corresponds to Vin and at t2 Vref corresponds to Vhv.

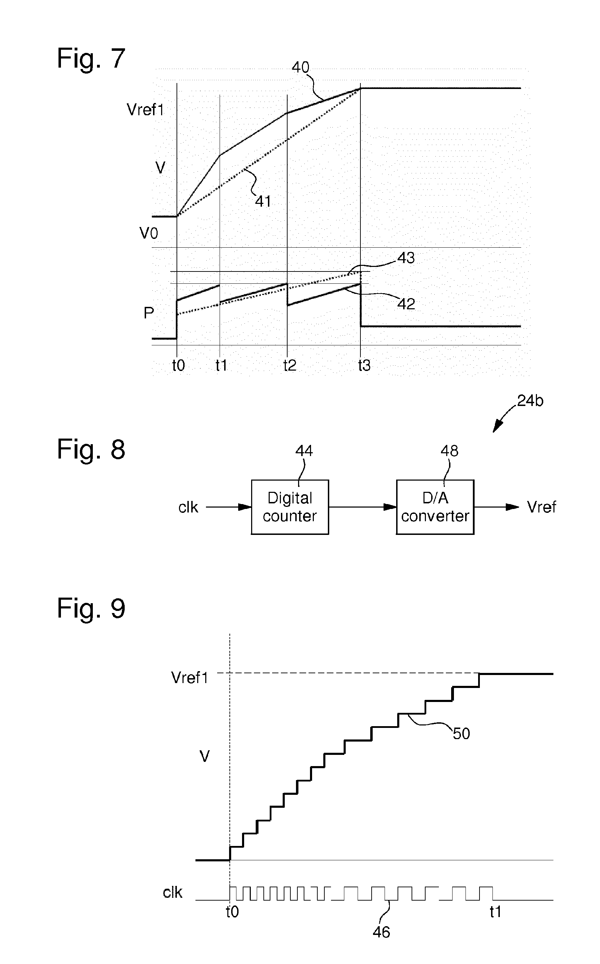

It will be appreciated that in alternative examples of the first embodiment there may be further current sources and switches arranged in parallel with the first and second current sources and their respective switches. For example, a third current source and switch may be operated to provide an intermediate rate as shown in Figure 7. For example between t0 and t1 all the switches are closed; between t1 and t2 the first and the second switches are closed and the third switch is open; between t2 and t3 the first switch is closed and second and third switches are open. It will also be appreciated that in addition to the number of current sources and switches in parallel, the open and close times of the switches, together with the magnitude of the current sources can be selected to achieve a specific piece-wise linear curve for a particular application.

Figure 7 shows a comparison between a three stage piece-wise linear curve 40 of Vout and a single rate ramp-up 41 of Vout according to the prior art. The associated power consumption plots are shown respectively as 42 and 43, wherein it can be seen that the peak power consumption is less for the three stage piece-wise linear curve 40. In the above examples of the first embodiment, which are based on charging and discharging of the capacitor 36, the current is changed to achieve a piece-wise linear curve. However in a yet further example of the first embodiment the piece-wise linear curve may be achieved by having a constant current and changing the capacitance of the capacitor 36 at given times. It will also be appreciated that the ramp-up control unit 24a according to the first embodiment may be configured to directly control Vout, for example in an open loop system.

A second embodiment of a ramp-up control unit 24b will now be described, wherein a stepped curve is achieved. Figures 8 and 9 show a first example of the second embodiment, wherein a clock signal clk is supplied to an input of a digital counter 44. The digital counter 44 is operable to increase the counter content with each clock signal. In this example the clock input frequency 46 is adjusted as shown in Figure 9. The output of the counter 44 is supplied to a D/A converter 48 which creates an increasing Vref in the form of a stepped curve 50 with an increasing step period, as shown in Figure 9. The stepped curve 50 when averaged has a reduced gradient approaching Vref1 at t1 and a steeper gradient when diverging from V0 at t0. It will be appreciated that the digital counter and clock frequency may be selected to provide a specific shape of stepped curve for a particular application.

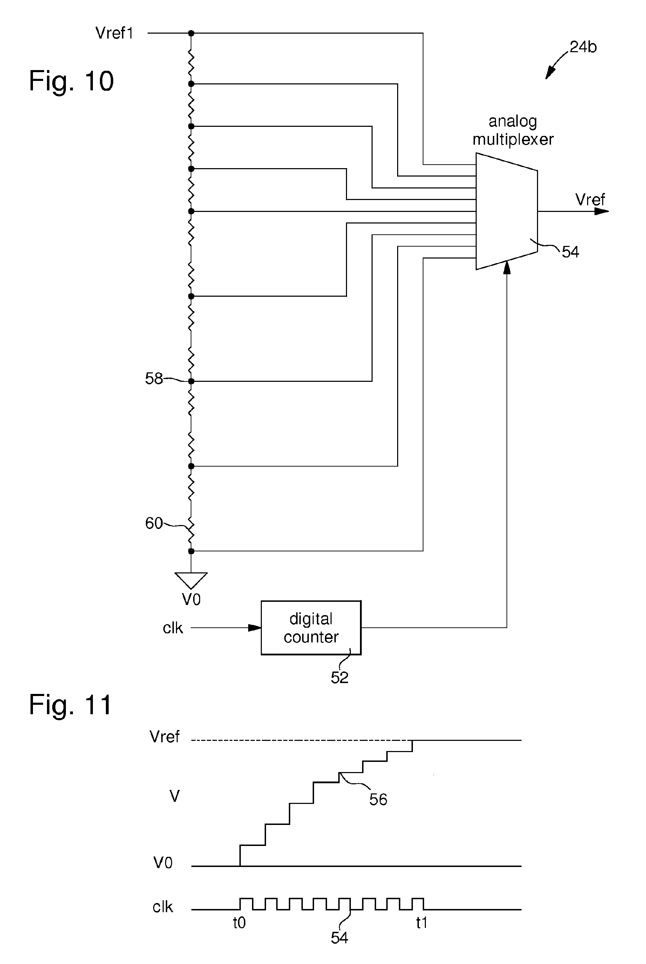

Figures 10 and 11 show a second example of the second embodiment, wherein a clock signal clk is supplied to an input of a digital counter 52. The digital counter 52 is operable to increase the counter content with each clock signal. In this example the clock input frequency 54 is constant, as shown in Figure 11. However the output of the counter 52 is supplied to a non-linear D/A converter 54. The non-linear D/A converter creates an increasing Vref in the form of a stepped curve 56 with a decreasing step magnitude, as shown in Figure 11. The stepped curve 56 when averaged has a reduced gradient approaching Vref1 at t1 and a steeper gradient when diverging from Vin at t0. In this particular example the non-linear D/A converter is an analogue multiplexer. The multiplexer is operable to select the input signals from nodes 58, which are arranged from V0 to Vref1 via resistive dividers that comprise resistors 60. It will be appreciated that the number of nodes 58 and the resistance of the resistors 60, which may have various configurations, may be selected to provide a specific stepped curve for a particular application.

As for the first embodiment in the second embodiment Vref1 is based on a reliably know value, for example it may be generated by a band-gap generator.

As for the first embodiment, in the second embodiment Vref is supplied to the comparator of the regulator unit 26 as shown in Figure 4. The comparator of the regulator unit 26 process Vref and Vmon and controls the charge pump unit 22 to provide Vout in corresponding proportions to Vref. For example, at t0 V0 corresponds to Vin and at t1 Vref corresponds to Vhv.

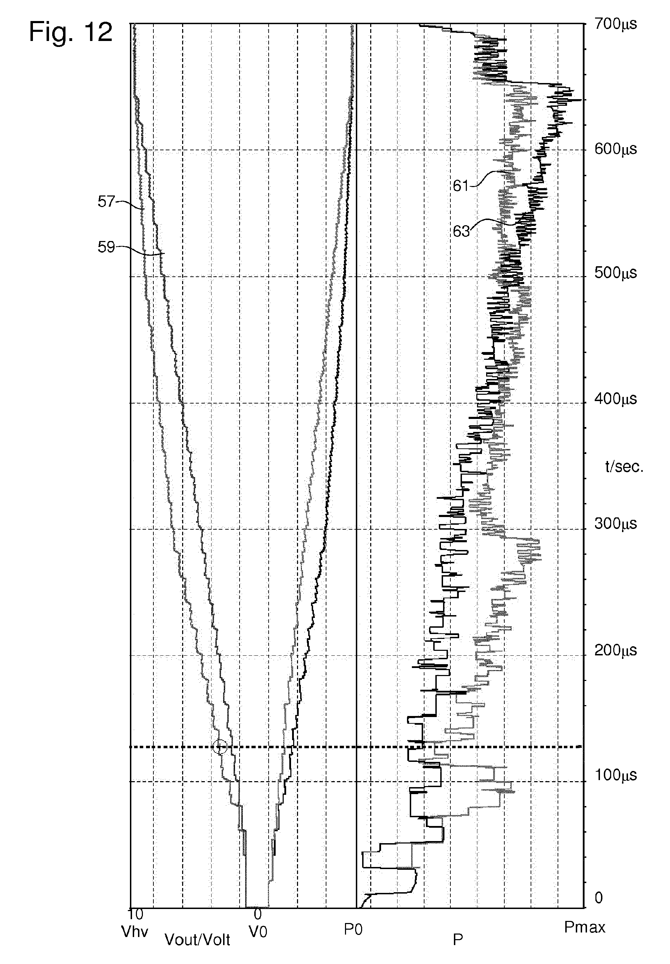

Figure 12 shows example experimental results for the second embodiment, wherein a stepped curve 57 of Vout is compared to a single rate stepped ramp-up 59 of Vout. The curve 57 is a non-linear ramp of the high voltage, whereas the curve 59 is a linear ramp of the high voltage. In this example, it will be appreciated that stepped curve 57, when average the smooth the stepping, gives a generally decreasing ramp rate, and that the single rate stepped ramp-up 59 when averaged gives a linear line, i.e. a constant ramp rate.

The associated power P consumption plots, which are plotted between P0 and Pmax, are shown respectively as 61 and 63. From the power consumption plots it can be seen that towards the end of the ramp (i.e. at time greater than about 500 μs) the peak power consumption for curve 61 depending on stepped curve 57 is less than for the curve 63 depending on the single rate stepped curve 59.

It will also be appreciated that the ramp-up control unit according to the second embodiment 24b may be configured to directly control Vout, for example in an open loop system.

A third embodiment of an ramp-up control unit 24c will now be described, wherein an exponential curve is achieved. In an advantageous embodiment the exponential curve is achieved by an RC network. For instance, Figures 13 and 14 show an example of the third embodiment wherein an inverter 62 is arranged to receive a start signal and Vref1 to provide a switching operation. Said inverter 62 supplies constant signal Vref1' after switching of the start signal start_n. An RC network is connected to the inverter, with a resistor 66 in series with the inverter 62 and capacitor 68 connected to ground.

Vref is determined by the voltage over the capacitor 68, and is plotted as an example in Figure 14, wherein it can be seen that the exponential curve 70 has an exponentially decreasing gradient, with the gradient attenuating approaching Vref1. It will be appreciated that the values of the resistor 66 and capacitor 68 can be selected to achieve a particular curve 70 using the following relationship:

$$Vref= Vref1 \cdot (1 - e^{-t/RC})$$

Moreover, it will also be appreciated that other exponential relationships may be provided by means of alternative RC networks. For example more complicated arrangements comprising several capacitors and resistors.

As for the above embodiments, in the third embodiment Vref1 is based on a reliably know value, for example it may be generated by a band-gap generator.

As for the above embodiments, in the third embodiment Vref is supplied to the comparator of the regulator unit 26 as shown in Figure 4. The comparator of the regulator unit 26 process Vref and Vmon and controls the charge pump unit 22 to provide Vout in corresponding proportions to Vref. For example, at t0 V0 corresponds to Vin and at t1 Vref corresponds to Vhv.

Figure 15 shows a comparison between an exponential curve 70 of Vout and a single rate ramp-up 41 of Vout according to the prior art. The associated power consumption plots are shown respectively as 71 and 43, wherein it can be seen that the peak power consumption is less for the exponential curve 40.

It will also be appreciated that the ramp-up control unit according to the third embodiment 24c may be configured to directly control Vout, for example in an open loop system. For instance, the ramp-up control unit may comprise a similar RC circuit, through which Vhv propagates to provide an increasing Vout with an exponentially degreasing rate.

A fourth embodiment of a ramp-up control unit 24d will now be described. In this embodiment the ramp-up control unit 24d is configured to manipulate the Vhv directly from the output of the charge pump unit 22. It will be appreciated that the ramp-up control unit 24d may be configured to manipulate Vout to provide a range of ramp-up curves with a decreasing rate as Vout approaches Vhv, for example, those according to the first, second or third embodiments. In the example of Figure 16 the ramp-up curve is piecewise linear. This is achieved by a divider comprising a capacitor 72 and a current source 74. The voltage over the current source 74 is output to an inverter 76. The capacitor 72 is charged by current source 74. If the charge rate is slower than the rising of the high voltage Vhv, then the voltage at the input of the inverter 76 goes high and the inverter is toggled. The inverter can be configured such that the output of the inverter can disable the charge pump unit 22 until the voltage on the inverter input drops again under a threshold of the inverter. The ramping of Vhv is limited by the charging of the capacitor by the current source and the slope can be changed by the value of the current source. The value of the current source can be changed by the switching of several sources in parallel, for example, by using an arrangement as shown in Figure 5.

It is to be noted that the aforementioned embodiments describe a positive voltage output of Vout, however it will be appreciated that they could be made for a negative voltage output, for example between 0 V and - 15 V, or other voltage.

It is to be noted that in the aforementioned embodiments Vhv can be in the order of 5-15 V. Vref1 can be in the order of 0.5-2 V.

The above control unit 23 can be used with a range of known charge pumps. Suitable charge pumps are provided in 'On-Chip High-Voltage Generation in NMOS Integrated Circuits Using an Improved Voltage Multiplier Technique', John F. Dickson, IEEE Journal of Solid-State Circuits, Vol. Sc-11, No. 3, June 1976, which is incorporated herein by reference.

## Claims

1. A charge pump circuit (20) comprising a charge pump unit (22), the charge pump unit being operable to output a voltage which increases from a first voltage to a second voltage, the second voltage being higher than the first voltage, **characterised in that**:

   the charge pump circuit (20) further comprises a control unit (23) configured to control a ramp-up of the output voltage by a variable ramp rate which comprises at least a first rate which precedes a second rate, the first rate being greater than the second rate, and the second rate being applied as the output voltage approaches that of the second voltage.

2. The charge pump circuit (20) according to the claim 1, wherein the control unit (23) is operable to apply the first rate when the output voltage is proximate in magnitude to the low or zero voltage, and the second rate is applied when the output voltage is proximate in magnitude to the second voltage.

3. The charge pump circuit (20) according to any one of the preceding claims, wherein the control unit (23) is operable to increase the output voltage over a ramp-up time, wherein first rate is applied over a first half of the ramp-up time and the second rate is applied over a second half of the ramp-up time.

4. The charge pump circuit (20) according to any one of the preceding claims, wherein the control unit (23) is configured such that the second rate is less than a rate achieved when the output voltage is increased from the first voltage to the second voltage at a constant rate over the same ramp-up time.

5. The charge pump circuit (20) according to any one of the preceding claims, wherein the control unit (23) is configured such that the first rate is greater than a rate achieved when the output voltage is increased from the first voltage to the second voltage at a constant rate over the same ramp-up time.

6. The charge pump circuit (20) according to any one of the preceding claims, wherein the control unit (23) is configured such that a plurality of ramp-up rates are applied with decreasing rates from first voltage to second voltage of the output voltage of the charge pump unit (22).

7. The charge pump circuit (20) according to any one of claims 1 to 5, wherein the control unit (23) is configured such that a plurality of ramp-up rates are applied with consecutively decreasing rates from first voltage to second voltage of the output voltage of the charge pump unit (22).

8. The charge pump circuit (20) according to any one of the preceding claims, wherein the control unit (23) is operable to increase the output voltage in a linear-piecewise manner.

9. The charge pump circuit (20) according to any one of claims 1 to 7, wherein the control unit (23) is operable to increase the output voltage in an exponentially decreasing manner or is operable to increase the output voltage with a curved profile having a decreasing rate.

10. The charge pump circuit (20) according to any one of the preceding claims, wherein the control unit (23) includes a regulator unit (26) to regulate the output voltage of the charge pump unit (22), and a ramp-up control unit (24a, 24b, 24c, 24d) to ramp-up the output voltage from a low or zero voltage to a second voltage.

11. The charge pump circuit (20) according to any one of claims 1 to 9, wherein the control unit (23) includes a ramp-up control unit (24a, 24b, 24c, 24d), which is operable to define a reference ramp-up voltage, the reference ramp-up voltage increasing from an initial voltage to a reference voltage, wherein the reference ramp-up voltage is representative of and is used to control the output voltage of the charge pump unit (22).

12. The charge pump circuit (20) according to claim 11, the reference ramp-up voltage increases from the initial voltage to the reference voltage in a linear piece-wise manner.

13. The charge pump circuit (20) according to claim 11, wherein the reference ramp-up voltage increases from the initial voltage to the reference voltage in a stepped manner.

14. The charge pump circuit (20) according to claim 11, wherein the reference ramp-up voltage increases from the initial voltage to the reference voltage in an exponentially decreasing manner.

15. A method of operating a charge pump circuit (20), the method comprising operating a charge pump unit (22) of the charge pump circuit (20) to output an output voltage that increases from a first voltage to a second voltage, the second voltage being higher than the first voltage, **characterised in that**:

    a control unit (23) of the charge pump circuit ramps-up of the output voltage by a variable ramp rate which comprises at least a first rate which precedes a second rate, the first rate being greater than the second rate, and the second rate being applied as the output voltage approaches that of the second voltage.

16. A memory device comprising a memory unit, **characterised in that** the memory device comprises a charge pump circuit (20) according to any one of claims 1 to 14, wherein the charge pump circuit (20) is operable to supply an output voltage to the memory unit to enable the memory unit to perform one or more operations.

17. A method of operating a memory unit of a memory device according to claim 16, the method comprising operating a charge pump unit (22) of a charge pump circuit (20) to output an output voltage to the memory unit that increases from a first voltage to a second voltage to enable the memory unit to perform one or more operations, the second voltage being higher than the first voltage, **characterised in that**:

    a control unit (23) of the charge pump circuit (20) ramps-up the output voltage by a variable ramp rate which comprises at least a first rate which precedes a second rate, the first rate being greater than the second rate, and the second rate being applied as the output voltage approaches that of the second voltage.

## Fig. 1a
(Prior Art)

2

VIN $\overset{+}{\underset{-}{=}}$    VIN    4

## Fig. 1b
(Prior Art)

2

4

2·VIN

VIN $\overset{+}{\underset{-}{=}}$

## Fig. 2
(Prior Art)

6

Vout

8

Pump

14

12

16

Vmon

Vref

18

$+$

$-$

10

## Fig. 3
(Prior Art)

Vhv

Vout

Vin

P

t0      tr      ts

# Fig. 4

Vout

Vmon

Vref

Pump

20

22

23

26

# Fig. 5

Vref1

I1

I2

28

30

32

34

S1

S2

Vref

36

38

24a

# Fig. 6

S1

S2

32

34

Vref1

Vref

V

V0

t0   t1   t2

## Fig. 7

## Fig. 8

## Fig. 9

Fig. 10

Vref1

analog
multiplexer

24b

Vref

54

58

60

V0

clk

digital
counter

52

Fig. 11

Vref

V

56

V0

clk

t0          54          t1

Fig. 12

## Fig. 13

24c

Vref1

Vref1'

R

Vref

62    66    68    C

## Fig. 14

Vref1

Vref1'

Vref

70

0V

start_n

## Fig. 15

Vref1

V

70

41

V0

P

43

71

t0          t1

## Fig. 16

24d

Vhv

72

76

Vout

74

Europäisches
Patentamt

European
Patent Office

Office européen
des brevets

## EUROPEAN SEARCH REPORT

Application Number

EP 13 18 9899

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 945 870 A (CHU MICHAEL H [US] ET AL) 31 August 1999 (1999-08-31) * the whole document * | 1-17 | INV. H02M1/36 H02M3/07 G11C5/14 |
| X | US 2013/077411 A1 (NGUYEN QUI VI [US] ET AL) 28 March 2013 (2013-03-28) * paragraphs [0004], [0017], [0020] - [0022]; figures 3,4 * | 1-8,10, 15-17 | |
| X | US 2009/189586 A1 (TIEW KEE CHEE [US]) 30 July 2009 (2009-07-30) * paragraphs [0010], [0011], [0026]; figures 1,3 * | 1,2,4-7, 9,15 | |
| A | US 2002/140463 A1 (CHEUNG PAUL [US]) 3 October 2002 (2002-10-03) * abstract * * figure 2 * | 1-7 | |

TECHNICAL FIELDS
SEARCHED (IPC)

H02M
G11C

The present search report has been drawn up for all claims

| Place of search | Date of completion of the search | Examiner |
|---|---|---|
| The Hague | 21 March 2014 | van Wesenbeeck, R |

EPO FORM 1503 03.82 (P04C01)

## ANNEX TO THE EUROPEAN SEARCH REPORT
## ON EUROPEAN PATENT APPLICATION NO.

EP 13 18 9899

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2014

| Patent document cited in search report | | Publication date | Patent family member(s) | | Publication date |
|---|---|---|---|---|---|
| US 5945870 | A | 31-08-1999 | NONE | | |
| US 2013077411 | A1 | 28-03-2013 | US | 2013077411 A1 | 28-03-2013 |
| | | | WO | 2013043269 A2 | 28-03-2013 |
| US 2009189586 | A1 | 30-07-2009 | NONE | | |
| US 2002140463 | A1 | 03-10-2002 | US | 2002140463 A1 | 03-10-2002 |
| | | | US | 2004228189 A1 | 18-11-2004 |
| | | | US | 2006013044 A1 | 19-01-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JOHN F. DICKSON.** IEEE Journal of Solid-State Circuits. *Multiplier Technique,* June 1976, vol. Sc-11 (3